# EUROPEAN PATENT SPECIFICATION

(11) **EP 2 132 873 B1**
(45) Date of publication and mention of the grant of the patent: **22.08.2012**
(21) Application number: 08744804.9
(22) Date of filing: 31.03.2008
(51) Int. Cl.: H03K 19/0185, H03K 17/10, H03K 19/017

(54) **LEVEL SHIFTER CIRCUIT INCORPORATING TRANSISTOR SNAP-BACK PROTECTION**
PEGELUMSETZERSCHALTUNG MIT TRANSISTOR-EINSCHNAPPSCHUTZ
CIRCUIT DE DÉCALAGE DE NIVEAU INCORPORANT UNE PROTECTION DE RETRAIT DE TRANSISTOR

(30) Priority: 31.03.2007 US 695011; 31.03.2007 US 695013
(43) Date of publication of application: 16.12.2009
(73) Proprietor: Sandisk 3D LLC, Milpitas, CA 95035 (US)
(72) Inventor: THORP, Tyler J., Milpitas, California 95035-7932 (US); FASOLI, Luca G., Milpitas, California 95035-7932 (US)
(74) Representative: Hitchcock, Esmond Antony
(86) International application number: PCT/US2008/058933
(87) International publication number: WO 2008/121977

(56) References cited:
- EP-B1- 0 935 346
- JP-A- 09 018 328
- JP-A- 2006 295 252
- US-A- 5 723 987
- US-A1- 2002 079 545
- US-A1- 2002 175 737
- US-B1- 6 476 637
- RWANG-CHERNG CHOW ET AL: "New voltage level shifting circuits for low power CMOS interface applications" IEEE INTERNATIONAL MIDWEST SYMPOSIUM,, vol. 1, 25 July 2004 (2004-07-25), pages 1_533-1_536, XP010739027 ISBN: 978-0-7803-8346-3
- LIM J-H ET AL: "A NOVEL HIGH-SPEED AND LOW-VOLTAGE CMOS LEVEL-UP/DOWN SHIFTER DESIGN FOR MULTIPLE-POWER AND MULTIPLE-CLOCK DOMAIN CHIPS" IEICE TRANSACTIONS ON ELECTRONICS, ELECTRONICS SOCIETY, TOKYO, JP LNKD- DOI:10.1093/IETELE/E90-C.3.644, vol. E90C, no. 3, 1 March 2007 (2007-03-01), pages 644-648, XP001541508 ISSN: 0916-8524
- TRAN C Q ET AL: "Low-power high-speed level shifter design for block-level dynamic voltage scaling environment" INTEGRATED CIRCUIT DESIGN AND TECHNOLOGY, 2005. ICICDT 2005. 2005 INTE RNATIONAL CONFERENCE ON AUSTIN, TX, USA MAY 9-11, 2005, PISCATAWAY, NJ, USA,IEEE LNKD- DOI:10.1109/ICICDT.2005.1502637, 9 May 2005 (2005-05-09), pages 229-232, XP010832287 ISBN: 978-0-7803-9081-2

## Description

The present invention relates to level shifting circuits for generating a high voltage domain output signal responsive to a low voltage domain input signal.

Level shifting circuits are commonly used to convert a signal from a low voltage domain to a high voltage domain. For example, a logic signal may be generated by circuitry which is powered by a low-voltage power supply voltage, such as VDD (e.g., 1.5 volts), and thus have output levels generally corresponding to VDD and ground. However many circuits, such as programmable memory devices, utilize higher voltages for internal signals in programming and erase modes than in a read mode. Frequently such devices use an internal power supply voltage from 3-10 volts or higher, which may be known as VPP. Consequently, it is useful to generate level shifted "versions" of these low-level logic signals, which level shifted signals have output levels of VPP and ground, to provide appropriate voltages on various switched circuit nodes, especially during programming and erase modes of operation.

As semiconductor devices have become smaller, the voltage which may be safely applied across various devices has decreased. For example, then maximum voltage that may be safely applied from drain to source terminals of a non-conducting N-channel MOSFET transistor (i.e., an "off' NMOS transistor) is frequently known as a breakdown voltage. However, when such a transistor is conducting, the maximum voltage that may be safely applied from drain to source terminals is frequently a lower voltage than the breakdown voltage. Such a voltage is known as the "snap-back" voltage, which is named for the visual appearance of the transistor's I-V curve when subjected to such conditions.

Snap-back concerns frequently limit the operating voltage achievable in a level shifting circuit, and may pose significant reliability concerns in such level shifting circuits. Snap-back problems are more problematic in NMOS devices than in NMOS devices, because of the greater susceptibility of electrons being trapped in oxides and surface traps than the susceptibility for boles being trapped. Snap-back can cause catastrophic failure of a device, and hence the failure of a circuit incorporating such a device. Consequently, snap-back problems are more likely to arise in sub-circuits used to discharge a high voltage node, such as an output node of a level shifter circuit.

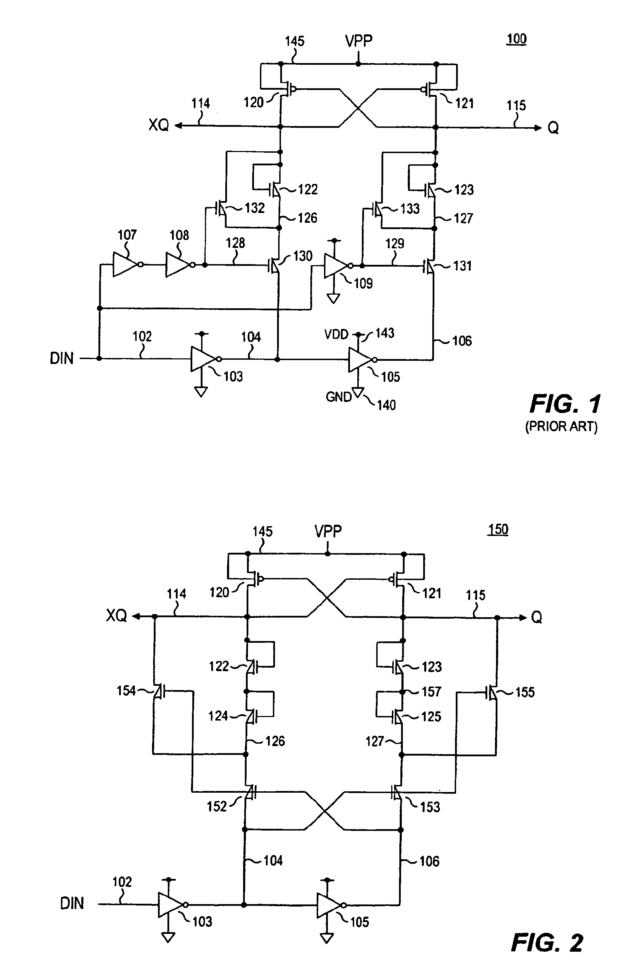

Referring now to Fig. 1, a snap-back protected level shifter 100 is shown. A logic signal DIN is conveyed on node 102, and is the input signal for this level shifter 100. This input signal need not correspond to a "data" signal, but can be any logic signal, such as an address signal, a decoded or pre-decoded address signal, a control signal, or any other logic signal generally having one of two logic states for a low-voltage domain as its signal levels. The inverters 103, 105, 107, 108, and 109 all belong to this low-voltage domain, being powered by VDD (node 143) and ground (node 140), and thus the signals generated on nodes 104, 106 128, and 129 are each "VDD-level" signals (i.e., having a "high" level of VDD, and a "low" level of ground). These low-voltage inverters 103, 105, 107, 108, and 109 are implemented with low-voltage transistors having a typical threshold voltage (V_{T}) of 300-600 mV, and which devices are not suitable to connection to high voltage nodes.

A second power supply VPP is conveyed on node 145. Such a power supply may be provided from an external source, or may be generated internally within the overall circuit (e.g., a FLASH memory device or other programmable memory device). Moreover, the voltage conveyed on the VPP node 145 may vary depending upon the mode of operation. For example, the magnitude of the VPP voltage in a read mode may be much lower (e.g., 3 volts) than in a write, programming, or erase mode. For the description that follows, we shall assume the VPP voltage to be a high voltage (e.g., 10 volts, such as for a programming mode) well above the snap-back voltage for typical NMOS transistors.

The complementary XQ, Q output nodes 114, 115 are coupled to VPP by cross-coupled PMOS transistors 120, 121, and are coupled to ground by matching discharge circuits. The XQ output node 114 is discharged by native transistors 122, 130, 132, and the output pull-down transistor within inverter 103, all as described below. Similarly, the Q output node 115 is discharged by native transistors 123, 131, 133, and the output pull-down transistor within inverter 105. Such native transistors usually have a threshold voltage near zero volts.

High voltage NMOS devices may be available in some semiconductor processes. However, a suitable high voltage device for 10 volt operation likely requires a threshold voltage high enough (e.g., V_{T} = 600-1200 mV) that a VDD level signal on its gate (e.g., as low as 1.2 volts) would barely turn on such a device, if at all.

To understand the operation of this circuit, assume initially that the DIN signal is high (i.e., VDD), and that consequently the Q output node 115 is also high (i.e., VPP) and that the XQ output node 114 is low (i.e., ground). Next assume that the DIN node transitions from a high to a low level (i.e., from VDD to ground). Clearly the intended operation is to bring the voltage of the Q output node 115 to ground, and to bring the voltage of the XQ output node 114 to VPP. With DIN at ground, node 128 is brought to ground, transistor 130 is turned off, and the XQ output node 114 is free to be driven high by PMOS transistor 120 when turned on by the decreasing voltage on the Q output node 115 that is coupled to the gate of transistor 120 (described in detail below).

With DIN at ground, node 106 is also driven to ground, and node 129 is driven high (i.e., VDD) by inverter 109. However, since transistor 131 is very sensitive to snap-back, the rise time of node 129 is intentionally slowed so that the gate-to-source voltage of transistor 131 develops very slowly, and thus transistor 131 turns on very slowly, to thereby discharge node 127 (i.e., reducing the drain-to-source voltage on transistor 131) before the gate-to-source voltage of transistor 131 reaches a voltage that would cause a snap-back condition. Such intentional slowing may be accomplished by using transistors in inverter 109 that have a longer electrical length than the usual "minimum length" transistors for a given semiconductor process. The level shift diode 123 is provided to decrease the voltage on node 127 to a lesser value than the voltage of the Q output node 115, to reduce the voltage otherwise impressed across transistor 131. As the voltage of node 129 continues to rise, and as the voltage of node 127 continues to fall, transistor 133 will eventually turn on, bypassing the level shift diode 123, and providing a discharge path from the Q output node 115, through transistor 133, transistor 131, and the inverter 105 pull-down transistor, to ground. This discharge path is suitable to drive the Q output node 115 fully to ground, without resulting in a low level that "rides" above ground by a diode drop.

As the Q output 115 is being discharged, the PMOS pull-up transistor 121 initially remains fully turned on until the voltage of the Q output node 115 is reduced by at least a PMOS threshold voltage (V_{T}) so that PMOS transistor 120 turns on, charging up the complementary XQ output node 114, and turning off PMOS transistor 121 to thereby allow the discharge path to completely discharge the Q output node 115, and to achieve a quiescent state with no standby power dissipation. Such intentionally weakened pull-down paths require that the corresponding pull-up paths must also be weakened. In other words, if the discharge path is weakened, the pull-up path must also be weakened if the voltage on the output node is able to be reduced by at least a PMOS threshold voltage.

The weakened drive strength in both the charging (i.e., pull-up) path and the discharging (i.e., pull-down) path increases the delay through such a level shifter circuit, and thus reduces circuit performance. Moreover, the various transistors in the level shifter circuit must be sized for a given output load. As a result, no standard-sized level shifter circuit may be used with varying output capacitive loading without risking the reliability of the level shifter circuit.

Considerable efforts have been applied in the art to design around such snap-back concerns, which sometimes results in circuits having unusually high complexity to accomplish what might seem like a simple logic structure. Nonetheless, improvements in such level shifter circuits are always beneficial.

US 2002/0175737 discloses a circuit according to the preamble of Claim 1.

Improved level shift circuits are disclosed for level shifting an input signal corresponding to a first voltage domain, to generate an output signal or a pair of complementary output signals corresponding to a second higher voltage domain. Snap-black sensitive devices in a discharge circuit for a high voltage output node are protected by a voltage shifter circuit in series with the sensitive devices, to limit the voltage across a sensitive device irrespective of the loading on the output node, and even for a high capacitance output node at the highest output voltage. This may be achieved without requiring precise transistor sizing, as a function of the output loading, to carefully control how quickly certain transistors are turned fully on. The voltage shifter circuit is then bypassed to provide for an output low level that fully reaches the lower power supply rail.

In one aspect the invention provides a level shifter circuit comprising first and second load devices for respectively coupling first and second complementary output nodes to a first voltage supply node and first and second driver circuits respectively for coupling the first and second output nodes to a second voltage supply node. Each of the first and second driver circuits respectively comprises a voltage shifter circuit coupled between the respective output node and a respective intermediate node and a switching circuit responsive to an input signal and coupled between the respective intermediate node and the second voltage supply node. The voltage shifter circuit provides a large enough voltage drop to ensure that, for a voltage of the respective output node equal to the highest voltage operably coupled to the first voltage supply node, and the switching circuit being fully enabled in response to the input signal having teached its full enabling signal level, a voltage of the respective intermediate node does not exceed a maximum snap-back voltage of any device within the switching circuit, wherein the snap-back voltage is the maximum voltage that may be safely applied from drain to source terminals of a transistor when conducting. The driver circuits further comprises a bypass circuit coupled between the respective output node and the respective intermediate node.

In another aspect the invention provides a method for level shifting an input signal corresponding to a first voltage domain to generate complementary first and second output signals. The first and second output signals are conveyed on respective first and second output nodes. The method comprises in response to a change of the input signal from a first state to a second state of the first voltage domain coupling the first output node to a second voltage supply node by way of a first current path that includes a first voltage shifter circuit in series with a first switch device, to partially drive the voltage of said output node toward the second voltage supply node voltage. The first voltage shifter circuit provides a large enough voltage drop thereacross to ensure that, for a voltage of said first output node equal to the highest voltage in the second voltage domain, and the first switch device being fully enabled in response to the input signal having reached its full enabling signal level, a voltage across the first switch device does not exceed its maximum snap-back voltage, wherein the snap-back voltage is the maximum voltage that may be safely applied from drain to source terminals of a transistor when conducting; then coupling the first output node to the second voltage supply node by way of a second current path that includes a first bypass device in series with the first switch device, but excludes the first voltage shifter circuit, to drive the voltage of the first output node fully to the second voltage supply node voltage and coupling the second output node to a first voltage supply node, to drive the voltage of the second output node substantially to the voltage conveyed on the first voltage supply node. The first and second output signals correspond to a second voltage domain larger in magnitude than the first voltage domain.

The invention in several aspects is particularly suitable for implementation within an integrated circuit, including those integrated circuits having a memory array, for methods for operating such circuits, for systems incorporating such circuits, and for computer readable media encodings of such circuits, all as described herein in greater detail and as set forth in the appended claims. A wide variety of such integrated circuits is specifically contemplated, particularly those incorporating programmable memory arrays, including those having a three-dimensional memory array formed above a substrate.

The foregoing is a summary and thus contains, by necessity, simplifications, generalizations and omissions of detail. Consequently, those skilled in the art will appreciate that the foregoing summary is illustrative only and that it is not intended to be in any way limiting of the invention. Moreover, the inventive aspects described herein are contemplated to be used alone or in combination. Other aspects, inventive features, and advantages of the present invention, as defined solely by the claims, may be apparent from the detailed description set forth below.

### BRIEF DESCRIPTION OF THE DRAWINGS

The present invention may be better understood, and its numerous objects, features, and advantages made apparent to those skilled in the art by referencing the accompanying drawings.
Fig. 1, labeled prior art, is a schematic diagram of a level shifter circuit.
Fig. 2 is a schematic diagram of a level shifter circuit in accordance with some embodiments of the invention.
Fig. 3 is a waveform drawing illustrating switching behavior of the level shifter circuit depicted in Fig. 2.
Fig. 4 is a block diagram of a level shifter circuit in accordance with some embodiments of the invention.
Fig. 5 is a schematic diagram of a level shifter circuit in accordance with some embodiments of the invention.
Fig. 6 is a schematic diagram of a level shifter circuit in accordance with some embodiments of the invention.

The use of the same reference symbols in different drawings indicates similar or identical items.

### DETAILED DESCRIPTION

Referring now to Fig. 2, a level shifting circuit is shown that does not require intentionally weakened pull-down paths, and yet is protected from snap-back effects independent of output load. As before, a logic signal DIN is conveyed on node 102, and is inverted by low-voltage inverter 103 to generate the VDD-level control signal on node 104, which is inverted by low-voltage inverter 105 to generate the VDD-level control signal on node 106. The inverters 103, 105 may be viewed as belonging to the VDD voltage domain (i.e., the low voltage domain), and the input signal DIN conveyed on node 102 and the control signals conveyed on nodes 104, 106 may be viewed as VDD domain (i.e., low-voltage domain) signals having high and low levels respectively corresponding to VDD and ground.

The complementary XQ, Q output nodes 114, 115 are coupled to VPP by cross-coupled PMOS transistors 120, 121, and are coupled to ground by generally matching discharge circuits. The XQ output node 114 is discharged by native transistors 122, 124, 152, 154, and the low-voltage output pull-down transistor within inverter 103. Similarly, the Q output node 115 is discharged by native transistors 123, 125, 153, 155, and the low-voltage output pull-down transistor within inverter 105. The VPP voltage corresponds to a high voltage domain, and the output signals conveyed on nodes XQ, Q may be viewed as VPP domain (i.e., high-voltage domain) signals having high and low levels respectively corresponding to VPP and ground.

Again assume initially that the DIN signal is high, the Q output node 115 is high (i.e., VPP), and the XQ output node 114 is low (i.e., ground). When the DIN signal on node 102 transitions from a high to a low level, node 104 is driven to VDD, and node 106 is brought to ground. Thus, transistor 152 is turned off, and the XQ output node 114 is free to be driven high by PMOS transistor 120 when turned on by the decreasing voltage on the Q output node 115 that is coupled to the gate of transistor 120.

Transistor 153 is turned on when the rising voltage on node 104 exceeds the falling voltage on node 106. However, transistors 123, 125 form a voltage shifter circuit which reduces the maximum voltage on node 127, and transistor 153 may be turned on more quickly than the discharge transistor 131 in the level shifter circuit 100 shown in Fig. 1. As such, minimum length transistors may be used in the various transistors that drive the discharge path (e.g., inverters 103, 105), since no intentional delay need be introduced in turning on the discharge path.

As the voltage of node 127 falls, transistor 155 will eventually turn on, bypassing the level shift diodes 123, 125, and providing a discharge path from the Q output node 115, through transistor 155, transistor 153, and the inverter 105 pull-down transistor, to ground. This discharge path is suitable to drive the Q output node 115 fully to ground.

The operation of the cross-coupled PMOS loads 120, 121 is as before described in Fig. 1. However, since the discharge path may be implemented as a much stronger path, the ratio effects become easier (i.e., the discharge path can more easily overcome the pull-up transistor 121 conduction and generate a -VT gate-to-source voltage on transistor 120). Since the pull-down paths are more robust, the corresponding pull-up paths may also be more robust. This provides a shorter delay through the level shifter circuit, and thus increases circuit performance. Moreover, the various transistors need not be precisely sized for a given output load, so that a standard-sized level shifter circuit may be used with varying output capacitive loading without risking the correct operation and reliability of the level shifter circuit.

Since the pull-down path may be sized to be strong, and since the low voltage devices are very strong, node 106 will pull down robustly to ground. As a result, the gate-to-source voltage of transistor 153 will be equal to VDD to allow the maximum current through transistor 153. Since all three pull-down devices (i.e., transistors 123, 125, 153) are in saturation, the gate-to-source voltages for transistors 123 and 125 will also be equal to VDD (plus the additional VT due to body effect, and assuming all three transistors 123, 125, 131 are the same size). The bypass circuit (i.e., transistor 155) is not enabled until node 127 is below VDD, at which point the gate-to-source voltage of transistor 155 is around zero (i.e., its V_{T}). The voltage of the Q output node 115 at such time is therefore no higher than approximately 3*VDD, so the maximum V_{DS} across transistor 155 when initially turned on is no higher than 2*VDD (although it is likely somewhat higher due to the body effect described above).

The voltage shifter circuit formed by transistors 123, 125 (and likewise by transistors 122, 124 in the XQ discharge path) may be implemented using a variety of other structures and devices. For example, PMOS diodes, high voltage NMOS or PMOS transistors, resistors, or any other suitable structure resulting in a voltage drop thereacross when a current flows therethrough, may alternatively be used. As would be the case with a resistor, the voltage drop need not be constant across the voltage shifter circuit. In other embodiments, each voltage shifter circuit may include other numbers of series diodes, such as one diode, three diodes, etc.

Significantly, the propagation delay through the level shifter circuit 150 shown in Fig. 2 is far less than the delay through the level shifter circuit 100 shown in Fig. 1. In addition, the level shifter circuit 150 has three fewer inverters than does the level shifter circuit 100. Yet, the level shifter circuit 150 need not be carefully scaled as a function of the capacitive load on its outputs. All of these are useful advantages of this circuit.

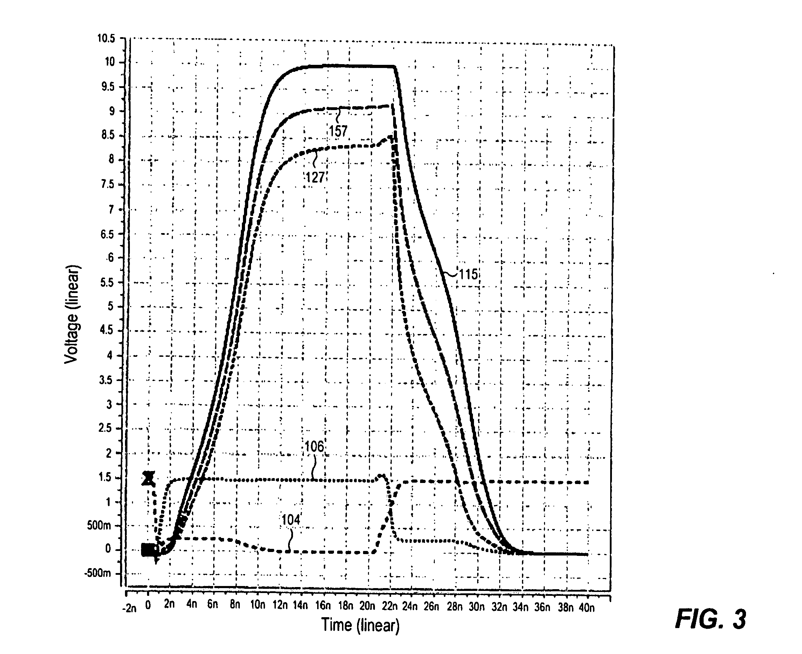

Fig. 3 depicts exemplary waveforms for the level shifter circuit shown in Fig. 2, operating with a VDD voltage of 1.5 volts and a VPP voltage of 10 volts. This operation reflects a "fast PMOS/slow NMOS" process corner, which increases the difficulty of the NMOS transistors in the pull-down path overcoming the PMOS load transistor during switching, and is likely more susceptible to snap-back effects than other process corners. Of note, transistor 153 turns on at approximately 22 ns, and develops a gate-to-source voltage approaching VDD (actually about 1200 mV) at about 22.8 ns. By that time, the voltage of node 127 has fallen to about 5.5 volts, and thus the drain-to-source voltage across transistor 153 has already dropped to below about 5.5 volts. For an exemplary semiconductor process, the nominal snap-back voltage (V_{DS}) for a native transistor is about 6.5 volts, assuming a V_{GS} equal to VDD (e.g., 1.5v). The voltage shifter circuit (transistors 123, 127) provides a *large* enough voltage drop to ensure that, for a voltage of the Q output node 115 equal to the VPP voltage, the voltage across the transistor 153 cannot exceed its maximum snap-back voltage.

Also of note, bypass transistor 155 turns on at approximately 28ns when the voltage of node 127 drops below the voltage of node 104. By that time, the voltage of the Q output node 115 has fallen to about 4.5 volts, and thus the drain-to-source voltage across transistor 155 is about 3.0 volts. The voltage shifter circuit (transistors 123, 127) provides a *small* enough voltage drop to ensure that the voltage across the transistor 155, when it is turned on, cannot exceed its maximum snap-back voltage.

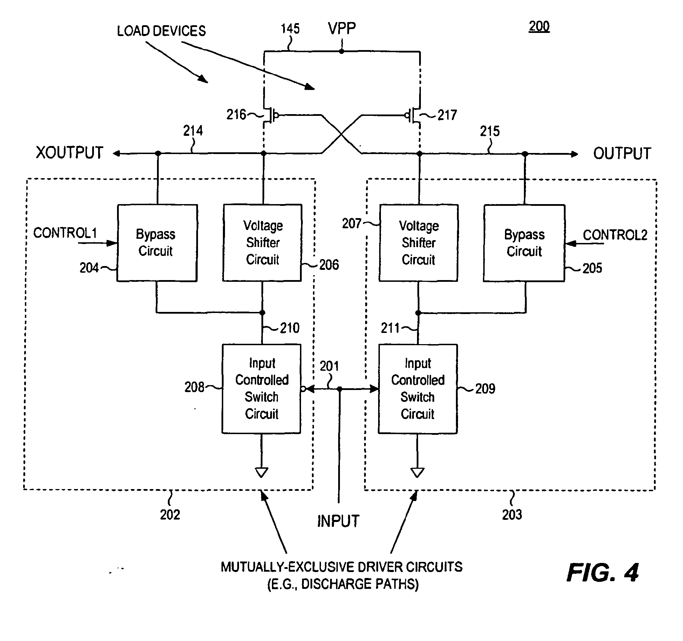

Referring now to Fig. 4, a block diagram 200 is depicted which represents certain level shifter embodiments in accordance with the invention. An input logic signal INPUT is conveyed on node 201, and is coupled to a pair of mutually-exclusive driver circuits (e.g., discharge paths) 202, 203. Complementary XOUTPUT, OUTPUT nodes 214, 215 are respectively coupled to VPP by cross-coupled load devices (here shown as PMOS transistors 216, 217), and are respectively coupled to ground by the mutually-exclusive driver circuits 202, 203. As implied by the dashed lines in both the source and drain connections to transistors 216, 217, other devices may be included in such load circuits (i.e., the transistors 216, 217 need not themselves be *directly* coupled to VPP and to nodes 214, 215).

The driver circuit 203 for the OUTPUT node 215 includes a voltage shifter circuit 207 in parallel with a bypass circuit 205, together coupled in series with an input-controlled switch circuit 209 which is enabled when the INPUT signal is high. Initially, the OUTPUT node 215 is discharged by current flow through the voltage shifter circuit 207 and through the input-controlled switch circuit 209. After the intermediate node 211 reaches a safe voltage, the bypass circuit 205 is enabled by a CONTROL2 signal, and the OUTPUT node 215 is discharged fully to ground by current flow through the bypass circuit 205 and the input-controlled switch circuit 209. When the voltage across the bypass circuit 205 decreases below the magnitude of the voltage across the voltage shifter circuit 207, current flow through the voltage shifter circuit 207 ceases, and the OUTPUT node 215 is discharged solely by the bypass circuit 205 and the input-controlled switch circuit 209.

The discharge path 202 for the complement XOUTOUT node 214 includes a voltage shifter circuit 206 in parallel with a bypass circuit 204 (responsive to a CONTROL1 signal), together coupled in series with an input-controlled switch circuit 208 which is enabled when the INPUT signal is low (note the inverting "bubble" on its input). Operation is identical to that of the discharge path 203, except for the obvious polarity change.

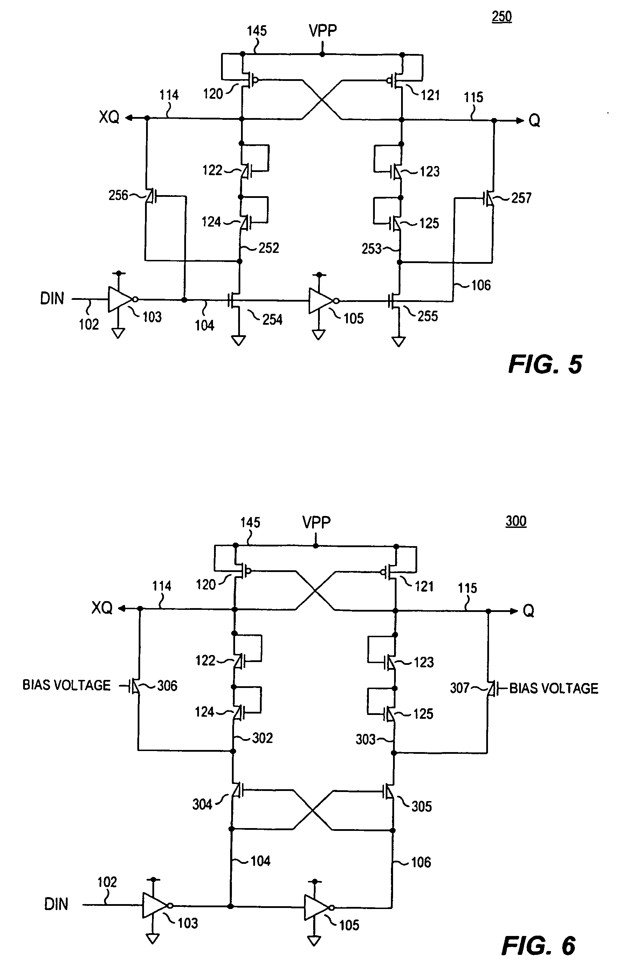

Referring now to Fig. 5, another level shifter circuit 250 is shown. The discharge path for the Q output node 115 includes a voltage shifter circuit (native transistors 123, 125), a bypass circuit (native transistor 257), and an input-controlled switch circuit (enhancement transistor 255, controlled by DIN through inverters 103, 105). In this case, the current path to ground does not flow through the inverter 105. The discharge path for the XQ output node 114 includes a voltage shifter circuit (native transistors 122, 124), a bypass circuit (native transistor 256), and an input-controlled switch circuit (enhancement transistor 254, controlled by DIN through inverter 103). As before, cross-coupled PMOS transistors 120,121 serve as respective load devices for the XQ, Q output nodes 114, 115. This embodiment is useful when the lowest VDD voltage is sufficiently larger than the highest enhancement mode threshold voltage, so that a VDD-level signal on node 104 can always turn on transistor 254 (and likewise that a VDD-level signal on node 106 can always turn on transistor 255).

Referring now to Fig. 6, another level shifter circuit 300 is shown which is similar to that shown in Fig. 2, but with a bias voltage acting as a control voltage for the two bypass circuits. The discharge path for the Q output node 115 includes a voltage shifter circuit (transistors 123, 125), a bypass circuit (transistor 307 having a bias voltage coupled to its gate terminal), and an input-controlled switch circuit (transistor 305 and inverter 105). The discharge path for the XQ output node 114 includes a voltage shifter circuit (transistors 122, 124), a bypass circuit (transistor 306 having a bias voltage coupled to its gate teminal), and an input-controlled switch circuit (transistor 304 and inverter 103). As before, cross-coupled PMOS transistors 120,121 serve as respective load devices for the XQ, Q output nodes 114, 115. The bias voltage coupled to the gates of transistors 306, 307 may be conveniently chosen to be VDD, or may be chosen to another higher or lower DC voltage to achieve bypass circuit turn-on at an appropriate voltage of the intermediate nodes 302, 303.

In an exemplary embodiment, a level-shifter circuit includes: (a) a first voltage supply node for operably receiving a first voltage; (b) a second voltage supply node for operably receiving a second voltage; (c) first and second load devices for respectively coupling first and second complementary output nodes to the first voltage; (d) first and second driver circuits for respectively coupling the first and second complementary output nodes to the second voltage, each of said first and second driver circuits respectively comprising: (1) voltage shifting means for providing on a respective intermediate node a voltage that, relative to a voltage of the respective output node, is level-shifted toward the second voltage by a certain magnitude; (2) switching means, responsive to an input signal, for coupling the respective intermediate node to the second voltage; and (3) bypass means for coupling the respective output node to the respective intermediate node, and thereby to the second voltage; (4) wherein the certain magnitude is chosen so that, for a respective output node at the first voltage and the switching means being fully enabled in response to the input signal, the level-shifted voltage of the respective intermediate node differs from the second voltage by no more than a maximum snap-back voltage of any device within the switching means.

In another exemplary embodiment, a level-shifter circuit includes: (a) first and second voltage supply nodes; (b) first and second complementary output nodes; (c) first and second intermediate nodes; (d) first and second cross-coupled load devices respectively coupled between the first and second output nodes and the first voltage supply node; (e) first and second voltage shifter circuits respectively coupled between the first and second output nodes and the first and second intermediate nodes; (f) first and second bypass transistors respectively coupled between the first and second output nodes and the first and second intermediate nodes; and (g) first and second cross-coupled switch transistors respectively coupled between the first and second intermediate nodes and the second voltage supply node.

Methods for making a product incorporating a level shifter circuit are also contemplated. In an exemplary embodiment, a method includes: (a) forming first and second load devices for respectively coupling first and second complementary output nodes to a first voltage supply node; (b) forming first and second mutually exclusive driver circuits respectively for coupling the first and second output nodes to a second voltage supply node, each of the first and second driver circuits respectively comprising: (1) a voltage shifter circuit coupled between the respective output node and a respective intermediate node; (2) a bypass circuit coupled between the respective output node and the respective intermediate node; and (3) a switching circuit responsive to an input signal and coupled between the respective intermediate node and the second voltage supply node; (4) wherein the voltage shifter circuit provides a large enough voltage drop to ensure that, for a voltage of the respective output node equal to the highest voltage operably coupled to the first voltage supply node, and the switching circuit being fully enabled in response to the input signal, a voltage of the respective intermediate node does not exceed a maximum snap-back voltage of any device within the switching circuit.

As used herein, a voltage supply node may be coupled to an externally generated source of voltage, or to an internally generated voltage by a circuit such as a voltage divider, a charge pump or other boosting circuit, a DC-DC converter circuit, or any other circuit for generating a source of voltage usable by other circuitry. Such nodes may also be described as power supply nodes. The ground reference node (i.e., VSS, "ground") may also be described as voltage supply node.

An output node such as the XQ, Q output nodes may be described herein as such for convenience but may, of course, be buffered further before actually being conveyed as an "output" to receiving circuitry. Moreover, both such XQ, Q output nodes (and/or any buffered versions thereof) need not be actually conveyed to any receiving circuitry, as there are many cases in which a level shifter circuit having a single polarity "output" may be desirable.

As used herein, coupled means either directly or indirectly. A transistor, switch circuit, or other switchable current path may be viewed as being fully enabled when one or more control signals controlling such device or structure have substantially reached their full enabling voltage or signal level. A voltage shifter circuit (sometimes referred to as a voltage shifter "block") may be implemented by any circuit structure providing a voltage drop thereacross for a given current flowing therethrough. Such a voltage drop may be substantially a constant voltage drop for any magnitude of current flow (i.e., a "perfect battery"), but such is not required. In practice, the magnitude of the voltage drop may decrease at low values of current, and may not be a particularly constant voltage drop for any range of current. Examples include one or more diode-connected transistors in series, one or more physical diodes in series, one or more resistors in series, parallel combinations of such structures, etc. As used herein, two mutually-exclusive driver circuits (e.g., mutually-exclusive discharge paths) may include a brief overlap during which both such circuits are partially or fully conductive, but in steady state one of such circuits (e.g., paths) is conductive and the other is non-conductive.

As contemplated by certain embodiments described herein, an N-channel "native" transistor may be formed identically as a high-voltage NMOS transistor, but without receiving the channel implant that such high voltage devices receive to set the higher threshold voltage of such high voltage devices. In preferred embodiments, such native transistors have a nominal threshold voltage of 0 volts (e.g., V_{T} = -200mV to +200mV). The circuits described herein may be formed using well known semiconductor fabrication techniques.

While embodiments are described herein having positive voltages relative to a ground reference supply, other embodiments are specifically contemplated having negative voltages, or having both positive and negative voltages, relative to a ground reference supply. For example, the "dual" circuit for the described embodiments, achieved by interchanging NMOS and PMOS transistors and inverting the polarity of signal and power supply voltages, are also contemplated.

Regarding general terminology used herein, it will be appreciated by one skilled in the art that any of several expressions may be equally well used when describing the operation of a circuit including the various signals and nodes within the circuit. Any kind of signal, whether a logic signal or a more general analog signal, takes the physical form of a voltage level (or for some circuit technologies, a current level) of a node within the circuit. It may be correct to think of signals being conveyed on wires or buses. For example, one might describe a particular circuit operation as "the output of circuit 10 drives the voltage of node 11 toward VDD, thus asserting the signal OUT conveyed on node 11." This is an accurate, albeit somewhat cumbersome expression. Consequently, it is well known in the art to equally describe such a circuit operation as "circuit 10 drives node 11 high," as well as "node 11 is brought high by circuit 10," "circuit 10 pulls the OUT signal high" and "circuit 10 drives OUT high." Such shorthand phrases for describing circuit operation are more efficient to communicate details of circuit operation, particularly because the schematic diagrams in the figures clearly associate various signal names with the corresponding circuit blocks and node names. For convenience, an otherwise unnamed node conveying the CLK signal may be referred to as the CLK node. Similarly, phrases such as "pull high," "drive high," and "charge" are generally synonymous unless otherwise distinguished, as are the phrases "pull low," "drive low," and "discharge." It is believed that use of these more concise descriptive expressions enhances clarity and teaching of the disclosure. It is to be appreciated by those skilled in the art that each of these and other similar phrases may be interchangeably used to describe common circuit operation, and no subtle inferences should be read into varied usage within this description.

A transistor may be conceptualized as having a control terminal which controls the flow of current between a first current handling terminal (or current carrying terminal) and a second current handling terminal. An appropriate condition on the control terminal causes a current to flow from/to the first current handling terminal and to/from the second current handling terminal (for typical operating voltages of the first and second current handling terminals). In a bipolar transistor, the first current handling terminal may be deemed the emitter, the control terminal deemed the base, and the second current handling terminal deemed the collector. An MOS transistor may likewise be conceptualized as having a control terminal which controls the flow of current between a first current handling terminal and a second current handling terminal. Although MOS transistors are frequently discussed as having a drain, a gate, and a source, in most such devices the drain is interchangeable with the source. This is because the layout and semiconductor processing of the transistor is symmetrical (which is typically not the case for bipolar transistors). For an N-channel MOS transistor, the current handling terminal normally residing at the higher voltage is customarily called the drain. The current handling terminal normally residing at the lower voltage is customarily called the source. A sufficiently high voltage on the gate (relative to the source voltage) causes a current to therefore flow from the drain to the source (provided the respective voltage of the drain and source are different). For an enhancement mode N-channel device, a positive gate-to-source voltage greater than the threshold voltage (including body effect) is sufficient. The source voltage referred to in N-channel MOS device equations merely refers to whichever current handling terminal has the lower voltage at any given point in time. For example, the "source" of the N-channel device of a bidirectional CMOS transfer gate depends on which side of the transfer gate is at the lower voltage. To reflect this symmetry of most N-channel MOS transistors, the control terminal may be deemed the gate, the first current handling terminal may be termed the "drain/source", and the second current handling terminal may be termed the "source/drain". Such a description is equally valid for a P-channel MOS transistor, since the polarity between drain and source voltages, and the direction of current flow between drain and source, is not implied by such terminology. Alternatively, one current handling terminal may arbitrarily deemed the "drain" and the other deemed the "source", with an implicit understanding that the two are not distinct, but interchangeable.

Regarding power supplies, a single positive power supply voltage (e.g., a 2.5 volt power supply) used to power a circuit is frequently named the "VDD" power supply. In an integrated circuit, transistors and other circuit elements are actually connected to a VDD terminal or a VDD node, which is then operably connected to the VDD power supply. The colloquial use of phrases such as "tied to VDD" or "connected to VDD" is understood to

mean "connected to the VDD node", which is typically then operably connected to actually receive the VDD power supply voltage during use of the integrated circuit.

The reference voltage for such a single power supply circuit is frequently called "VSS." Transistors and other circuit elements are actually connected to a VSS terminal or a VSS node, which is then operably connected to the VSS power supply during use of the integrated circuit. Frequently the VSS terminal is connected to a ground reference potential, or just "ground." Describing a node which is "grounded" by a particular transistor or circuit (unless otherwise defined) means the same as being "pulled low" or "pulled to ground" by the transistor or circuit.

The block diagrams herein may be described using the terminology of a single node connecting the blocks. Nonetheless, it should be appreciated that, when required by the context, such a "node" may actually represent a pair of nodes for conveying a differential signal, or may represent multiple separate wires (e.g., a bus) for carrying several related signals or for carrying a plurality of signals forming a digital word.

While circuits and physical structures are generally presumed, it is well recognized that in modern semiconductor design and fabrication, physical structures and circuits may be embodied in computer readable descriptive form suitable for use in subsequent design, test or fabrication activities as well as in resultant fabricated semiconductor integrated circuits. Accordingly, claims directed to traditional circuits or structures may, consistent with particular language thereof, read upon computer readable encodings and representations of same, whether embodied in media or combined with suitable reader facilities to allow fabrication, test, or design refinement of the corresponding circuits and/or structures. The invention is contemplated to include circuits, related methods of operation, related methods for making such circuits, and computer-readable medium encodings of such circuits and methods, all as described herein, and as defined in the appended claims. As used herein, a computer-readable medium includes at least disk, tape, or other magnetic, optical, semiconductor (e.g., flash memory cards, ROM), or electronic medium and a network, wireline, wireless or other communications medium. An encoding of a circuit may include circuit schematic information, physical layout information, behavioral simulation information, and/or may include any other encoding from which the circuit may be represented or communicated.

The foregoing detailed description has described only a few of the many possible implementation of the present invention. For this reason, this detailed description is intended by way of illustration, and not by way of limitations. Variations and modifications of the embodiments disclosed herein may be made based son the description set forth herein, without departing from the scope of the invention. Moreover, the embodiments described above are specifically contemplated to be used alone as well as in various combinations. It is only the following claims, that are intended to define the scope of this invention.

## Claims

1. A level shifter circuit (150; 200; 250; 300) comprising:
first (120; 216) and second (121: 217) load devices for respectively coupling first (114; 214) and second (115; 215) complementary output nodes to a first voltage supply node (145);
first (202) and second (203) driver circuits respectively for coupling the first (114; 214) and second (115; 215) output nodes to a second voltage supply node, each of the first (202) and second (203) driver circuits respectively comprising:
a voltage shifter circuit (122-125; 206; 207) coupled between the respective output node (114, 115; 214, 215) and a respective intermediate node (126, 127; 210, 211; 252, 253; 302, 303); and
a switching circuit (103, 105, 152, 153; 208, 209; 254, 255; 304, 305) responsive to an input signal and coupled between the respective intermediate node (126, 127; 210, 211; 252, 253; 302, 303) and the second voltage supply node;
**CHARACTERISED IN THAT**:
the voltage shifter circuit (122-125; 206; 207) provides a large enough voltage drop to ensure that, for a voltage of the respective output node (114, 115; 214, 215) equal to the highest voltage operably coupled to the first voltage supply node (145), and the switching circuit (103, 105, 152, 153; 208, 209; 254, 255; 304, 305) being fully enabled in response to the input signal having teached its full enabling signal level, a voltage of the respective intermediate node (126, 127; 210, 211; 252, 253; 302, 303) does not exceed a maximum snap-back voltage of any device within the switching circuit (103, 105, 152, 153; 208, 209; 254, 255; 304, 305), wherein the snap-back voltage is the maximum voltage that may be safely applied from drain to source terminals of a transistor when conducting;
the driver circuits further comprising a bypass circuit (154. 155; 204, 205; 256, 257; 306, 307) coupled between the respective output node (114, 115; 214, 215) and the respective intermediate node (126, 127; 210, 211; 252, 253; 302, 303).

2. The circuit as recited in claim 1, wherein the first (122, 124; 206) and second (123, 125; 207) voltage shifter circuits each provides a sufficiently low magnitude voltage drop to ensure that a voltage impressed across the first (154; 204; 256; 306) and second bypass circuits, when conductive, cannot exceed a maximum snap-back voltage of any device within the first (155; 205; 257; 307) and second bypass circuits.

3. The circuit as recited in claim 1 wherein:
the first switching circuit comprises a first switch transistor (152; 304) having a source terminal coupled to a first control node (104) and having a gate terminal coupled to a second control node (106); and
the second switching circuit comprises a second switch transistor (153; 305) having a source terminal coupled to the second control node (106) and having a gate terminal coupled to the first control node (104).

4. The circuit as recited in claim 3, further comprising:
a first inverting circuit (103) coupled to a third voltage supply node and the second voltage supply node, responsive to the input signal, and having an output coupled to the first control node (104); and
a second inverting circuit (105) coupled to the third voltage supply node and the voltage supply node, having an input coupled to the first control node (104), and having an output coupled to the second control node (106);
said third voltage supply node (143) for operably receiving a voltage substantially less than that received by the first voltage supply node (145).

5. The circuit as recited in claim 4, wherein:
the first bypass circuit comprises a first bypass transistor (154) having a gate terminal coupled to the second control node (106); and
the second bypass circuit comprises a second bypass transistor (155) having a gate terminal coupled to the first control node (104).

6. The circuit as recited in claim 4 further comprising a bias voltage node coupled to a respective gate terminal of the first (306) and second (307) bypass transistors.

7. The circuit as recited in claim 5, wherein:
the first (120; 216) and second (121; 217) load devices comprise cross-coupled load devices respectively coupled between the first (114; 214) and second (115; 215) output nodes and the first voltage supply node (145).

8. The circuit as recited in any preceding claim, wherein the first (152; 208; 304) and second (153; 209; 305) switching circuits comprise high voltage native transistors having a nominally 0 volt threshold voltage.

9. The circuit as recited in any preceding claim, wherein the first (122, 124; 206) and second (123, 125; 207) voltage shifter circuits each respectively comprise a plurality of series connected high voltage native transistors.

10. A method for level shifting an input signal corresponding to a first voltage domain, to generate complementary first and second output signals, said first and second output signals conveyed on respective first (114; 214) and second (115; 215) output nodes, said method comprising:
in response to a change of the input signal from a first state to a second state of the first voltage domain:
coupling the first output node (114; 214) to a second voltage supply node by way of a first current path that includes a first voltage shifter circuit (127, 124; 206) in series with a first switch device (103, 152; 254; 304), to partially drive the voltage of said output node (114; 214) toward the second voltage supply node voltage;
**CHARACTERISED IN THAT**:
said first voltage shifter circuit (127, 124; 206) provides a large enough voltage drop thereacross to ensure that, for a voltage of said first output node (114; 214) equal to the highest voltage in the second voltage domain, and the first switch device being fully enabled in response to the input signal having teached its full enabling signal level, a voltage across the first switch device (103, 152; 254; 304) does not exceed its maximum snap-back voltage, wherein the snap-back voltage is the maximum voltage that may be safely applied from drain to source terminals of a transistor when conducting; then
coupling the first output node (114; 214) to the second voltage supply node by way of a second current path that includes a first bypass device (154; 204; 256; 306) in series with the first switch device (103, 152; 254; 304), but excludes the first voltage shifter circuit (127, 124; 206), to drive the voltage of the first output node (114; 214) fully to the second voltage supply node voltage; and
coupling the second output node (115; 215) to a first voltage supply node (145), to drive the voltage of the second output node (115; 215) substantially to the voltage conveyed on the first voltage supply node (145);
wherein the first and second output signals correspond to a second voltage domain larger in magnitude than the first voltage domain.

11. The method as recited in claim 10 wherein said first voltage shifter circuit (127, 124; 206) provides a small enough voltage drop thereacross to ensure that a voltage impressed across the first bypass device (154; 204; 256; 306), when conductive, cannot exceed a maximum snap-back voltage of any device within the first bypass circuit.

12. The method as recited in claim 10, further comprising:
generating the first and second complementary control signals in the first voltage domain, responsive to the input signal;
coupling the first control signal to the source terminal (104) of the first switch device (152; 304) and to the gate terminal of the second switching device; and
coupling the second control signal to the gate terminal (106) of the first switch device (152; 304) and to the source terminal of the second switching device.

13. The method as recited in claim 12, wherein the second current path further comprises an output device of a logic circuit belonging to the first voltage domain coupled between the first switch device and the second voltage supply node.

14. The method as recited in claim 13, further comprising coupling a bias voltage to a gate terminal of the first bypass device (306).

15. The method as recited in claim 13, further comprising coupling the same control signal to both the gate terminal of the first switch device (152) and the gate terminal of the first bypass device (154).

## Patentansprüche

1. Pegelumsetzerschaltung (150; 200; 250; 300), Folgendes umfassend:
eine erste (120; 216) und eine zweite (121; 217) Lasteinrichtung zum jeweiligen Ankoppeln eines ersten (114; 214) und eines zweiten (115; 215) komplementären Ausgangsknotens an einen ersten Spannungsversorgungsknoten (145);
eine erste (202) und eine zweite (203) Treiberschaltung zum jeweiligen Ankoppeln des ersten (114; 214) und zweiten (115; 215) Ausgangsknotens an einen zweiten Spannungsversorgungsknoten, wobei jede der ersten (202) bzw. zweiten (203) Treiberschaltung Folgendes umfasst:
eine Spannungsumsetzerschaltung (122-125; 206; 207), zwischen dem jeweiligen Ausgangsknoten (114, 115; 214, 215) und einem jeweiligen Zwischenknoten (126, 127; 210, 211; 252, 253; 302, 303) angekoppelt, und
einen Schaltkreis (103, 105, 152, 153; 208, 209; 254, 255; 304, 305), der auf ein Eingangssignal anspricht und zwischen dem jeweiligen Zwischenknoten (126, 127; 210, 211; 252, 253; 302, 303) und dem zweiten Spannungsversorgungsknoten angekoppelt ist;
**dadurch gekennzeichnet, dass**:
die Spannungsumsetzerschaltung (122-125; 206; 207) einen hinreichend großen Spannungsabfall bereitstellt, um sicherzustellen, dass, für eine Spannung des jeweiligen Ausgangsknotens (114, 115; 214, 215) gleich der höchsten Spannung, die betriebsbereit an den ersten Spannungsversorgungsknoten (145) gekoppelt ist, wobei der Schaltkreis (103, 105, 152, 153; 208, 209; 254, 255; 304, 305) als Reaktion auf das Eingangssignal voll aktiviert ist, das seinen vollen Aktivierungssignalpegel erreicht hat, eine Spannung des jeweiligen Zwischenknotens (126, 127; 210, 211; 252, 253; 302, 303) eine maximale Rückschnappspannung einer Einrichtung innerhalb des Schaltkreises (103, 105, 152, 153; 208, 209; 254, 255; 304, 305) nicht übersteigt, worin die Rückschnappspannung die maximale Spannung ist, die gefahrlos von Drain-Anschlüssen an Source-Anschlüsse eines Transistors im Leitungszustand angelegt werden kann;
die Treiberschaltungen außerdem eine Bypass-Schaltung (154, 155; 204, 205; 256, 257; 306, 307) umfassen, die zwischen dem jeweiligen Ausgangsknoten (114, 115; 214, 215) und dem jeweiligen Zwischenknoten (126, 127; 210, 211; 252, 253; 302, 303) angekoppelt ist.

2. Schaltung nach Anspruch 1, worin jede der ersten (122, 124; 206) und zweiten (123, 125; 207) Spannungsumsetzerschattung einen Spannungsabfall hinreichend kleiner Größe bereitstellt, um sicherzustellen, dass eine der ersten (154; 204; 256; 306) und zweiten Bypass-Schaltung aufgedrückte Spannung im Leitungszustand eine maximale Rückschnappspannung einer Einrichtung innerhalb der ersten (155; 205; 257; 307) und zweiten Bypass-Schaltung nicht überteigen kann.

3. Schaltung nach Anspruch 1, worin:
der erste Schaltkreis einen ersten Schalttransistor (152; 304) mit einem Source-Anschluss umfasst, der an einen ersten Steuerknoten (104) gekoppelt ist, und einem Gate-Anschluss, der an einen zweiten Steuerknoten (106) gekoppelt ist; und
der zweite Schaltkreis einen zweiten Schalttransistor (153; 305) mit einem Source-Anschluss umfasst, der an den zweiten Steuerknoten (106) gekoppelt ist, und einem Gate-Anschluss, der an den ersten Steuerknoten (104) gekoppelt ist.

4. Schaltung nach Anspruch 3, außerdem umfassend:
eine erste invertierende Schaltung (103), an einen dritten Spannungsversorgungsknoten und den zweiten Spannungsversorgungsknoten gekoppelt, auf das Eingangssignal ansprechend und mit einem Ausgang, der an den ersten Steuerknoten (104) gekoppelt ist; und
eine zweite invertierende Schaltung (105), an den dritten Spannungsversorgungsknoten und den Spannungsversorgungsknoten gekoppelt, mit einem an den ersten Steuerknoten (104) gekoppelten Eingang und mit einem Ausgang, der an den zweiten Steuerknoten (106) gekoppelt ist;
den dritten Spannungsversorgungsknoten (143) zum betriebsfähigen Empfangen einer Spannung, die wesentlich kleiner ist, als die, die vom ersten Spannungsversorgungsknoten (145) empfangen wird.

5. Schaltung nach Anspruch 4, worin:
die erste Bypass-Schaltung einen ersten Bypass-Transistor (154) mit einem Gate-Anschluss umfasst, der an den zweiten Steuerknoten (106) gekoppelt ist; und
die zweite Bypass-Schaltung einen zweiten Bypass-Transistor (155) mit einem Gate-Anschluss umfasst, der an den ersten Steuerknoten (104) gekoppelt ist.

6. Schaltung nach Anspruch 4, außerdem einen Vorspannungsknoten umfassend, der an einen jeweiligen Gate-Anschluss des ersten (306) und zweiten (307) Bypass-Transistors gekoppelt ist.

7. Schaltung nach Anspruch 5, worin:
die erste (120; 216) und zweite (121; 217) Lasteinrichtung kreuzgekoppelte Lasteinrichtungen umfassen, die jeweils zwischen dem ersten (114; 214) und zweiten (115; 215) Ausgangsknoten und dem ersten Spannungsversorgungsknoten (145) gekoppelt sind.

8. Schaltung nach einem der vorhergehenden Ansprüche, worin der erste (152; 208; 304) und der zweite (153; 209; 305) Schaltkreis natürliche Hochspannungstransistoren umfassen, die eine Schwellenspannung von nominal 0 Volt haben.

9. Schaltung nach einem der vorhergehenden Ansprüche, worin jede der ersten (122, 124; 206) und zweiten (123, 125; 207) Spannungsumsetzerschaltung jeweils eine Vielzahl von in Serie geschalteten natürlichen Hochspannungstransistoren umfasst.

10. Verfahren zur Pegelumsetzung eines Eingangssignals, das einer ersten Spannungsdomäne entspricht, um ein komplementäres erstes und zweites Ausgangssignal zu erzeugen, wobei das erste und das zweite Ausgangssignal auf jeweiligen ersten (114; 214) und zweiten (115; 215) Ausgangsknoten transportiert werden, das Verfahren Folgendes umfassend:
als Reaktion auf eine Änderung des Eingangssignals von einem ersten Status in einen zweiten Status der ersten Spannungsdomäne:
Koppeln des ersten Ausgangsknotens (114; 214) an einen zweiten Spannungsversorgungsknoten mittels eines ersten Strompfads, der eine erste Spannungsumsetzerschaltung (127, 124; 206) enthält, die mit einer ersten Schalteinrichtung (103, 152; 254; 304) in Reihe geschaltet ist, um die Spannung des Ausgangsknotens (114; 214) teilweise zur zweiten Spannungsversorgungsknotenspannung zu treiben;
**dadurch gekennzeichnet, dass**:
die erste Spannungsunnsetzerschaltung (127, 124; 206) daran einen hinreichend großen Spannungsabfall anlegt, um sicherzustellen, dass, für eine Spannung des ersten Ausgangsknotens (114; 214) gleich der höchsten Spannung in der zweiten Spannungsdomäne, wobei die erste Schalteinrichtung als Reaktion darauf, dass das Eingangssignal seinen vollen Aktivierungssignalpegel erreicht hat, voll aktiviert ist, eine Spannung an der ersten Schalteinrichtung (103, 152; 254; 304) ihre maximale Rückschnappspannung nicht übersteigt, worin die Rückschnappspannung die maximale Spannung ist, die gefahrlos von Drain-Anschlüssen an Source-Anschlüsse eines Transistors im Leitungszustand angelegt werden kann; dann
Koppeln des ersten Ausgangsknotens (114; 214) an den zweiten Spannungsversorgungsknoten mittels eines zweiten Strompfades, der eine erste Bypass-Einrichtung (154; 204; 256; 306) enthält, die mit der ersten Schalteinrichtung (103, 152; 254; 304) in Reihe geschaltet ist, aber die erste Spannungsumsetzerschaltung (127, 124; 206) ausschließt, um die Spannung des ersten Ausgangsknotens (114; 214) voll an die zweite Spannungsversorgungsknotenspannung zu treiben; und
Koppeln des zweiten Ausgangsknotens (115; 215) an einen ersten Spannungsversorgungsknoten (145), um die Spannung des zweiten Ausgangsknotens (115; 215) im Wesentlichen an die Spannung zu treiben, die auf dem ersten Spannungsversorgungsknoten (145) transportiert wird;
worin das erste und das zweite Ausgangssignal einer zweiten Spannungsdomäne entsprechen, die eine größere Größe hat als die erste Spannungsdomäne.

11. Verfahren nach Anspruch 10, worin die erste Pegelumsetzerschaltung (127, 124; 206) einen hinreichend kleinen Spannungsabfall daran anlegt, um sicherzustellen, dass eine der ersten Bypass-Einrichtung (154; 204; 256; 306) aufgedrückte Spannung, wenn leitfähig, eine maximale Rückschnappspannung einer Einrichtung innerhalb der ersten Bypass-Schaltung nicht übersteigen kann.

12. Verfahren nach Anspruch 10, außerdem umfassend:
Erzeugen des ersten und zweiten komplementären Steuersignals in der ersten Spannungsdomäne, auf das Eingangssignal ansprechend;
Koppeln des ersten Steuersignals an den Source-Anschluss (104) der ersten Schalteinrichtung (152; 304) und an den Gate-Anschluss der zweiten Schalteinrichtung; und
Koppeln des zweiten Steuersignals an den Gate-Anschluss (106) der ersten Schalteinrichtung (152; 304) und an den Source-Anschluss der zweiten Schalteinrichtung.

13. Verfahren nach Anspruch 12, worin der zweite Strompfad außerdem eine Ausgangseinrichtung einer Logikschaltung umfasst, die zur ersten Spannungsdomäne gehört, die zwischen die erste Schalteinrichtung und den zweiten Spannungsversorgungsknoten gekoppelt ist.

14. Verfahren nach Anspruch 13, außerdem das Koppeln einer Vorspannung an einen Gate-Anschluss der ersten Bypass-Einrichtung (306) umfassend.

15. Verfahren nach Anspruch 13, außerdem das Koppeln desselben Steuersignals sowohl an den Gate-Anschluss der ersten Schalteinrichtung (152) als auch den Gate-Anschluss der ersten Bypass-Einrichtung (154) umfassend.

## Revendications

1. Circuit de décalage de niveau (150 ; 200 ; 250 ; 300) comprenant:
des premier (120 ; 216) et deuxième (121 ; 217) dispositifs de charge pour coupler respectivement des premier (114 ; 214) et deuxième (115 ; 215) noeuds de sortie complémentaires à un premier noeud d'alimentation en tension (145);
des premier (202) et deuxième (203) circuits de commande respectivement pour coupler les premier (114 ; 214) et deuxième (115 ; 215) noeuds de sortie à un deuxième noeud d'alimentation en tension, chacun des premier (202) et deuxième (203) circuits de commande comprenant respectivement:
un circuit de décalage de tension (122 à 125 ; 206 ; 207) couplé entre le noeud de sortie (114, 115 ; 214, 215) respectif et un noeud intermédiaire (126, 127 ; 210, 211 ; 252, 253 ; 302, 303) respectif; et
un circuit de commutation (103, 105, 152, 153 ; 208, 209 ; 254, 255 ; 304, 305) sensible à un signal d'entrée et couplé entre le noeud intermédiaire (126, 127 ; 210, 211 ; 252, 253 ; 302, 303) respectif et le deuxième noeud d'alimentation en tension ;
**caractérisé en ce que** :
le circuit de décalage de tension (122 à 125 ; 206 ; 207) fournit une chute de tension suffisamment grande pour garantir que, pour une tension du noeud de sortie (114, 115 ; 214, 215) respectif égale à la tension la plus élevée couplée fonctionnellement au premier noeud d'alimentation en tension (145), et le circuit de commutation (103, 105, 152, 153 ; 208, 209 ; 254, 255 ; 304, 305) étant totalement validé en réponse au signal d'entrée qui a atteint son niveau de signal de validation total, une tension du noeud intermédiaire (126, 127 ; 210, 211 ; 252, 253 ; 302, 303) respectif ne dépasse pas une tension de retrait maximum de n'importe quel dispositif dans le circuit de commutation (103, 105, 152, 153 ; 208, 209 ; 254, 255 ; 304, 305), dans lequel la tension de retrait est la tension maximum qui peut être appliquée en toute sécurité de la borne de drain à la borne de source d'un transistor lorsqu'il est conducteur;
les circuits de commande comprenant en outre un circuit de dérivation (154, 155 ; 204, 205 ; 256, 257 ; 306, 307) couplé entre le noeud de sortie (114, 115 ; 214, 215) respectif et le noeud intermédiaire (126, 127 ; 210, 211 ; 252, 253 ; 302, 303) respectif.

2. Circuit selon la revendication 1, dans lequel les premier (122, 124 ; 206) et deuxième (123, 125 ; 207) circuits de décalage de tension fournissent chacun une chute de tension d'amplitude suffisamment faible pour garantir qu'une tension appliquée aux bornes des premier (154 ; 204 ; 256 ; 306) et deuxième circuits de dérivation, lorsqu'ils sont conducteurs, ne puisse pas dépasser une tension de retrait maximum de n'importe quel dispositif dans les premier (155 ; 205 ; 257 ; 307) et deuxième circuits de dérivation.

3. Circuit selon la revendication 1, dans lequel:
le premier circuit de commutation comprend un premier transistor de commutation (152 ; 304) ayant une borne de source couplée à un premier noeud de commande (104) et ayant une borne de grille couplée à un deuxième noeud de commande (106); et
le deuxième circuit de commutation comprend un deuxième transistor de commutation (153 ; 305) ayant une borne de source couplée au deuxième noeud de commande (106) et ayant une borne de grille couplée au premier noeud de commande (104).

4. Circuit selon la revendication 3, comprenant en outre:
un premier circuit inverseur (103) couplé à un troisième noeud d'alimentation en tension et au deuxième noeud d'alimentation en tension, sensible au signal d'entrée, et ayant une sortie couplée au premier noeud de commande (104); et
un deuxième circuit inverseur (105) couplé au troisième noeud d'alimentation en tension et au noeud d'alimentation en tension, ayant une entrée couplée au premier noeud de commande (104), et ayant une sortie couplée au deuxième noeud de commande (106);
ledit troisième noeud d'alimentation en tension (143) servant à recevoir fonctionnellement une tension sensiblement inférieure à celle reçue par le premier noeud d'alimentation en tension (145).

5. Circuit selon la revendication 4, dans lequel:
le premier circuit de dérivation comprend un premier transistor de dérivation (154) ayant une borne de grille couplée au deuxième noeud de commande (106) ; et
le deuxième circuit de dérivation comprend un deuxième transistor de dérivation (155) ayant une borne de grille couplée au premier noeud de commande (104).

6. Circuit selon la revendication 4, comprenant en outre un noeud de tension de polarisation couplé à une borne de grille respective des premier (306) et deuxième (307) transistors de dérivation.

7. Circuit selon la revendication 5, dans lequel:
les premier (120 ; 216) et deuxième (121 ; 217) dispositifs de charge comprennent des dispositifs de charge à couplage transversal couplés respectivement entre les premier (114 ; 214) et deuxième (115 ; 215) noeuds de sortie et le premier noeud d'alimentation en tension (145).

8. Circuit selon l'une quelconque des revendications précédentes, dans lequel les premier (152 ; 208 ; 304) et deuxième (153 ; 209 ; 305) circuits de commutation comprennent des transistors natifs haute tension ayant une tension de seuil nominalement de 0 volt.

9. Circuit selon l'une quelconque des revendications précédentes, dans lequel les premier (122, 124; 206) et deuxième (123, 125 ; 207) circuits de décalage de tension comprennent chacun respectivement une pluralité de transistors natifs haute tension connectés en série.

10. Procédé de décalage du niveau d'un signal d'entrée correspondant à un premier domaine de tension, pour générer des premier et deuxième signaux de sortie complémentaires, lesdits premier et deuxième signaux de sortie étant transportés sur des premier (114 ; 214) et deuxième (115 ; 215) noeuds de sortie respectifs, ledit procédé consistant à :
en réponse à un changement du signal d'entrée d'un premier état à un deuxième état du premier domaine de tension:
coupler le premier noeud de sortie (114 ; 214) à un deuxième noeud d'alimentation en tension au moyen d'un premier trajet de courant qui comprend un premier circuit de décalage de tension (127, 124 ; 206) en série avec un premier dispositif de commutation (103, 152 ; 254 ; 304), pour commander partiellement la tension dudit noeud de sortie (114 ; 214) vers la deuxième tension de noeud d'alimentation en tension ;
**caractérisé en ce que**:
ledit premier circuit de décalage de tension (127, 124 ; 206) fournit une chute de tension suffisamment grande aux bornes de celui-ci pour garantir que, pour une tension dudit premier noeud de sortie (114 ; 214) égale à la tension la plus élevée dans le deuxième domaine de tension, et le premier dispositif de commutation étant totalement validé en réponse au signal d'entrée qui a atteint son niveau de signal de validation total, une tension aux bornes du premier dispositif de commutation (103, 152 ; 254 ; 304) ne dépasse pas sa tension de retrait maximum, dans lequel la tension de retrait est la tension maximum qui peut être appliquée en toute sécurité de la borne de drain à la borne de source d'un transistor lorsqu'il est conducteur ; ensuite
coupler le premier noeud de sortie (114 ; 214) au deuxième noeud d'alimentation en tension au moyen d'un deuxième trajet de courant qui comprend un premier dispositif de dérivation (154 ; 204 ; 256 ; 306) en série avec le premier dispositif de commutation (103, 152 ; 254 ; 304), mais qui ne comprend pas le premier circuit de décalage de tension (127, 124 ; 206), pour commander la tension du premier noeud de sortie (114 ; 214) totalement à la deuxième tension de noeud d'alimentation en tension ; et
coupler le deuxième noeud de sortie (115 215) à un premier noeud d'alimentation en tension (145), pour commander la tension du deuxième noeud de sortie (115 ; 215) sensiblement à la tension transportée sur le premier noeud d'alimentation en tension (145);
dans lequel les premier et deuxième signaux de sortie correspondent à un deuxième domaine de tension de plus grande amplitude que le premier domaine de tension.

11. Procédé selon la revendication 10 dans lequel ledit premier circuit de décalage de tension (127, 124 ; 206) fournit une chute de tension suffisamment faible aux bornes de celui-ci pour garantir qu'une tension appliquée aux bornes du premier dispositif de dérivation (154 ; 204 ; 256 ; 306), lorsqu'il est conducteur, ne puisse pas dépasser une tension de retrait maximum de n'importe quel dispositif dans le premier circuit de dérivation.

12. Procédé selon la revendication 10, consistant en outre à:
générer les premier et deuxième signaux de commande complémentaires dans le premier domaine de tension, en réponse au signal d'entrée ;
coupler le premier signal de commande à la borne de source (104) du premier dispositif de commutation (152 ; 304) et à la borne de grille du deuxième dispositif de commutation ; et
coupler le deuxième signal de commande à la borne de grille (106) du premier dispositif de commutation (152 ; 304) et à la borne de source du deuxième dispositif de commutation.

13. Procédé selon la revendication 12, dans lequel le deuxième trajet de courant comprend en outre un dispositif de sortie d'un circuit logique appartenant au premier domaine de tension couplé entre le premier dispositif de commutation et le deuxième noeud d'alimentation en tension.

14. Procédé selon la revendication 13, consistant en outre à coupler une tension de polarisation à une borne de grille du premier dispositif de dérivation (306).

15. Procédé selon la revendication 13, consistant en outre à coupler le même signal de commande à la fois à la borne de grille du premier dispositif de commutation (152) et à la borne de grille du premier dispositif de dérivation (154).
